(19)

Europäisches
Patentamt

European
Patent Office

Office européen
des brevets

(11)  **EP 2 960 430 B1**

(12)  **EUROPEAN PATENT SPECIFICATION**

(45) Date of publication and mention
of the grant of the patent:
**09.08.2017  Bulletin 2017/32**

(51) Int Cl.:
***E21B 49/00*** *(2006.01)*

(21) Application number: **15174003.2**

(22) Date of filing: **26.06.2015**

(54) **MULTILEVEL MONOTONE CONSTRAINED PRESSURE RESIDUAL MULTISCALE TECHNIQUES**

MEHRSTUFIGE MONOTONE EINGESCHRÄNKTE MEHRSKALIGE RESTDRUCKVERFAHREN

TECHNIQUES À MULTI-ÉCHELLE RÉSIDUELLES DE PRESSION DE CONTRAINTE MONOTONE MULTINIVEAU

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.06.2014  US 201462018318 P**

(43) Date of publication of application:
**30.12.2015  Bulletin 2015/53**

(73) Proprietors:
• **Services Pétroliers Schlumberger**
**75007 Paris (FR)**
Designated Contracting States:
**FR**
• **Logined B.V.**
**2586 BJ S Gravenhage (NL)**
Designated Contracting States:
**AL AT BE BG CH CY CZ DE DK EE ES FI GB GR HR HU IE IS IT LI LT LU LV MC MK MT NL NO PL PT RO RS SE SI SK SM TR**
• **Chevron Corporation**
**La Habra, CA 90631 (US)**
• **Total**
**92400 Courbevoie, Hauts-de-Seine (FR)**

(72) Inventors:
• **Lukyanov, Alexander**
**Cambridge, MA 02138 (US)**
• **Hajibeygi, Hadi**
**2611 LN Delft (NL)**
• **Natvig, Jostein**
**N-1353 Bærums Verk (NO)**
• **Bratvedt, Kyrre**
**Katy, TX 77450 (US)**

(74) Representative: **Schlumberger Cambridge Research Limited**
**High Cross**
**Madingley Road**
**Cambridge CB3 0EL (GB)**

(56) References cited:
**US-A1- 2011 098 998     US-A1- 2014 046 636**

• **HADI HAJIBEYGI ET AL: "Compositional Multiscale Finite-Volume Formulation", SPE JOURNAL, vol. 19, no. 02, 1 April 2014 (2014-04-01) , pages 316-326, XP055256544, US ISSN: 1086-055X, DOI: 10.2118/163664-PA**

**Description**

**BACKGROUND**

Mathematical formulation of multicomponent multiphase flow in heterogeneous large-scale porous media can entail highly heterogeneous multiscale nonlinear and linear parameters. Development of efficient numerical solutions, hence, can depend on correct treatments of both highly heterogeneous multiscale parameters and strongly nonlinear coupling terms. The former challenge can be addressed in a variety of ways, e.g., the Multiscale Finite Element (MsFEM) and Finite Volume Methods (MsFVM) like in US 2011/0098998 and the Multiscale Restriction Smoothed Basis (MsRSB).

In general, multiscale methods for reservoir treat the coupling between flow and transport equations by adopting a sequential (IMPES- or Sequential-Implicit-type) strategy. A high-stability sequential solution approach to reservoir simulation. Consequently, such approaches may be efficient when the coupling terms are not strong; however, when the coupling terms between flow and transport equations grow in importance, some sequential strategies may not be efficient. Strong coupling terms exist, e.g., in multiphase formulations with strong capillary and compositional effects. For these cases, fully implicit systems are generally more stable than sequential strategies.

**SUMMARY**

In accordance with some embodiments, a computer-implemented method for modeling behavior of at least one fluid in a reservoir is disclosed. The method includes obtaining a plurality of measurements of a plurality of physical parameters at a plurality of locations within the reservoir, the plurality of physical parameters including at least pressure; discretizing a system of partial differential equations that model, based on the plurality of measurements, the plurality of physical parameters; iterating, for each of a plurality of time steps, and until convergence upon a solution to the system of partial differential equations: approximating a rough solution to the system of partial differential equations; applying a constrained pressure residual technique to extract a system of pressure linear equations from the rough solution to the system of partial differential equations; applying a pre-smoothing technique at a fine scale to determine an approximate solution to the system of pressure linear equations; applying multi-scale multi-level processing to improve the approximate solution to the system of pressure linear equations; applying a post-smoothing technique at a fine scale to further improve the approximate solution to the system of pressure linear equations; and solving the system of partial differential equations for remaining physical parameters based on the further improved approximate solution to the system of pressure linear equations; and outputting the solution to the system of partial differential equations.

Various optional features of the above embodiments include the following. The outputting may include displaying a representation of a behavior of the at least one fluid in the reservoir. The method may include predicting fluid behavior in the reservoir based on the system of partial differential equations; and extracting fluid from the reservoir based on the predicting. The iterating may be performed in parallel by at least one hardware graphics processing unit. The method may include history matching the system of partial differential equations. The physical parameters may include pressure, flow rate, and composition. The system of partial differential equations may include at least one of hyperbolic partial differential equation and parabolic partial differential equations. The reservoir may include heterogeneous anisotropic porous media. The iterating may include applying a flexible general minimal residual method. At least one of the applying a pre-smoothing technique and the applying a post-smoothing technique may include applying at least one technique selected from the group consisting of: applying ILU(0), applying a Jacobi smoother, and applying a Gauss-Seidel smoother.

According to some embodiments, a computer system for modeling behavior of at least one fluid in a reservoir is disclosed. The system includes at least one electronic processor and persistent memory storing computer-interpretable instructions configured to cause the at least one processor to perform a method including: obtaining a plurality of measurements of a plurality of physical parameters at a plurality of locations within the reservoir, the plurality of physical parameters including at least pressure; discretizing a system of partial differential equations that model, based on the plurality of measurements, the plurality of physical parameters; iterating, for each of a plurality of time steps, and until convergence upon a solution to the system of partial differential equations: approximating a rough solution to the system of partial differential equations; applying a constrained pressure residual technique to extract a system of pressure linear equations from the rough solution to the system of partial differential equations; applying a pre-smoothing technique at a fine scale to determine an approximate solution to the system of pressure linear equations; applying multi-scale multi-level processing to improve the approximate solution to the system of pressure linear equations; applying a post-smoothing technique at a fine scale to further improve the approximate solution to the system of pressure linear equations; and solving the system of partial differential equations for remaining physical parameters based on the further improved approximate solution to the system of pressure linear equations; and outputting the solution to the system of partial differential equations.

Various optional features of the above embodiments include the following. The outputting may include displaying a representation of a behavior of the at least one fluid in the reservoir. The instructions may be further configured to cause the at least one processor to perform: predicting fluid behavior in the reservoir based on the system of partial differential equations; and extracting fluid from the reservoir based on the predicting. The system may include at least one graphics processing unit, wherein the iterating is performed in parallel by the at least one hardware graphics processing unit. The instructions may be further configured to cause the at least one processor to perform history matching the system of partial differential equations. The physical parameters may include pressure, flow rate, and composition. The system of partial differential equations may include at least one of hyperbolic partial differential equation and parabolic partial differential equations. The reservoir may include heterogeneous anisotropic porous media. The iterating may include applying a flexible general minimal residual method. At least one of the applying a pre-smoothing technique and the applying a post-smoothing technique may include applying at least one technique selected from the group consisting of: applying ILU(0), applying a Jacobi smoother, and applying a Gauss-Seidel smoother.

This summary is provided to introduce a selection of concepts that are further described below in the detailed description. This summary is not intended to identify key or essential features of the claimed subject matter, nor is it intended to be used as an aid in limiting the scope of the claimed subject matter.

## BRIEF DESCRIPTION OF THE DRAWINGS

The accompanying drawings, which are incorporated in and constitute a part of this specification, illustrate embodiments of the present teachings and together with the description, serve to explain the principles of the present teachings.

Fig. 1 illustrates an example partial set of actions for performing constrained proposed pressure residual Galerkin multiscale (CPR-GMS) and constrained pressure residual non-Galerkin multiscale (CPR-NGMS) methods.

Fig. 2 is a schematic diagram illustrating a method for flexible generalized minimal residual (FGMRES) preconditioned by a two-stage constrained pressure residual preconditioner.

Fig. 3 schematically illustrates a simulation grid with both a fine partition and coarse overlapping and non-overlapping subdomains.

Fig. 4 is a schematic diagram illustrating constrained proposed pressure residual Galerkin multiscale (CPR-GMS) and constrained pressure residual non-Galerkin multiscale (CPR-NGMS) methods.

Fig. 5 illustrates an example reservoir representation depicting a fine grid of 648,000 cells.

Fig. 6 illustrates graphs depicting field pressure and gas block saturation solutions for CPR-AMG and CPR-GMS.

Fig. 7 is a flowchart depicting a method according to some embodiments.

Fig. 8 illustrates a schematic view of a computing or processor system 100, according to an embodiment.

## DESCRIPTION OF EMBODIMENTS

Reference will now be made in detail to embodiments, examples of which are illustrated in the accompanying drawings and figures. In the following detailed description, numerous specific details are set forth in order to provide a thorough understanding of the invention. However, it will be apparent to one of ordinary skill in the art that the invention may be practiced without these specific details. In other instances, well-known methods, procedures, components, circuits and networks have not been described in detail so as not to unnecessarily obscure aspects of the embodiments.

It will also be understood that, although the terms first, second, etc. may be used herein to describe various elements, these elements should not be limited by these terms. These terms are only used to distinguish one element from another. For example, a first object or action could be termed a second object or action, and, similarly, a second object or action could be termed a first object or action, without departing from the scope of the invention. The first object or action, and the second object or action, are both, objects or actions, respectively, but they are not to be considered the same object or action.

The terminology used in the description of the invention herein is for the purpose of describing particular embodiments only and is not intended to be limiting of the invention. As used in the description of the invention and the appended claims, the singular forms "a," "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "comprises" and/or "comprising," when used in this specification, specify the presence of stated features, integers, actions, operations, elements, and/or components, but do not preclude the presence or addition of one or more other features, integers, actions, operations, elements, components, and/or groups thereof.

As used herein, the term "if" may be construed to mean "when" or "upon" or "in response to determining" or "in response to detecting," depending on the context.

Attention is now directed to processing procedures, methods, techniques and workflows that are in accordance with some embodiments. Some operations in the processing procedures, methods, techniques and workflows disclosed herein may be combined and/or the order of some operations may be changed.

The present disclosure provides computationally-efficient and highly-accurate techniques for modeling petroleum reservoir behavior. In particular, the present disclosure provides a consistent and robust numerical formulation for solutions to linear system of equations arising from the linearization of coupled nonlinear hyperbolic / parabolic (elliptic) partial differential equations (PDEs) of fluid flow in heterogeneous anisotropic porous media. The solutions may be used for both history matching and prediction. Some embodiments apply two-stage preconditioner and multiscale technology (e.g., multiscale restriction $\mathbf{R}$ and prolongation $\mathbf{P}$ operators).

This disclosure is set forth in three parts. Parts I and II describe embodiments of the from different perspectives. Part III describes suitable technology for implementations.

## I. Reservoir Modeling: A First Perspective

Numerical frameworks such as the following four examples can help analysis of nonlinear mixed hyperbolic / parabolic (elliptic) partial differential equations of fluid flow in heterogeneous anisotropic porous media:

(1) Multilevel Constrained Pressure Residual Galerkin Multiscale (ML-CPR-GMS) when $\mathbf{R} = \mathbf{P}^T$,
(2) Multilevel Constrained Pressure Residual Non-Galerkin Multiscale (ML-CPR-NGMS) when $\mathbf{R} \neq \mathbf{P}^T$,
(3) Monotone Multilevel Constrained Pressure Residual Galerkin Multiscale (MML-CPR-GMS) when $A_g \neq A_c = \mathbf{P}^T A \mathbf{P}$ (where $A_c$ and $A_g$ are the original and monotone coarse level pressure operators respectively), and
(4) Multilevel Constrained Pressure Residual Non-Galerkin Multiscale (MML-CPR-NGMS) when $A_g \neq A_c = \mathbf{R}A\mathbf{P}$.

The ML-CPR-GMS and ML-CPR-NGMS may be viewed as extensions of the conventional linear solver technique (based on CPR technology combined with multigrid methods). Such techniques may utilize fundamental advantages of the multiscale technology. However, these methods are not unconditionally monotone methods. The MML-CPR-GMS and MML-CPR-NGMS can provide a good approximation of the pressure field and, hence, satisfy a discrete maximum principle and avoid spurious oscillations. This may be achieved by applying ML-CPR-GMS and ML-CPR-NGMS methods with the correction to the coarse level operator $A_c$. The correction to the coarse level operator may be constructed in two actions. The first action may include choosing a sparsity pattern for the new coarse level operator $A_g$, and the second action may remove or "collapse" entries, either in $\mathbf{P}^T A \mathbf{P}$ or $\mathbf{R}A\mathbf{P}$, that lie outside of that sparsity pattern in order to satisfy a discrete maximum principle.

Such an approach may be useful in reservoir simulation. Unconventional reservoir simulations can involve several challenges not only arising from geological heterogeneities, but also from strong nonlinear physical coupling terms. The resulting governing reservoir equations may be of mixed hyperbolic / parabolic (elliptic) type thus making the initial-boundary value problem mathematically hard to solve. Existing upscaling and multiscale methods generally rely on a classical sequential formulation to treat the coupling between the nonlinear flow-transport equations. The sequential formulation is based on the decoupling of parabolic (or elliptic) variable such pressure from the hyperbolic variables such as saturations. In a simple case of immiscible incompressible two-phase flow (oil-water) with no capillary pressure and gravity in a heterogeneous incompressible porous media, the PDEs may be written as follows, by way of non-limiting example:

$$\phi \frac{\partial S_w}{\partial t} - \nabla \left( \lambda_w \nabla p\left( \vec{\mathbf{X}} \right) \right) = g_w\left( \vec{\mathbf{X}} \right) \text{ for } \vec{\mathbf{X}} \in \Omega \subset \mathbf{R}^D \tag{1}$$

$$\phi \frac{\partial S_0}{\partial t} - \nabla \left( \lambda_o \nabla p\left( \vec{\mathbf{X}} \right) \right) = g_o\left( \vec{\mathbf{X}} \right) \text{ for } \vec{\mathbf{X}} \in \Omega \subset \mathbf{R}^D \tag{2}$$

$$S_w + S_o = 1 \tag{3}$$

In Equations (1-3), the terms $S_\beta$, $g_\beta(\vec{\mathbf{X}})$, $\lambda_\beta$ denote, respectively, the saturation, source/sink term, mobility of fluid phase $\beta$, where $\beta = w, o$ for water and oil. The term $\phi$ represents the porosity. Due to $S_w + S_o = 1$, an equivalent statement to the system Equations (1-3) may be given as, by way of non-limiting example:

$$\phi \frac{\partial S_w}{\partial t} + \nabla\left(f_w \vec{\mathbf{u}}\left(\vec{\mathbf{X}}\right)\right) = g_w\left(\vec{\mathbf{X}}\right) \ \text{for}\ \vec{\mathbf{X}} \in \Omega \subset \mathbf{R}^D \tag{4}$$

$$\nabla\left(\vec{\mathbf{u}}\right) = g\left(\vec{\mathbf{X}}\right) \ \text{for}\ \vec{\mathbf{X}} \in \Omega \subset \mathbf{R}^D \tag{5}$$

In Equations (4) and (5), the term $\vec{\mathbf{u}}\left(\vec{\mathbf{X}}\right) = -\lambda \nabla p\left(\vec{\mathbf{X}}\right)$ represents the total velocity, and

$$g\left(\vec{\mathbf{X}}\right) = g_0\left(\vec{\mathbf{X}}\right) + g_w\left(\vec{\mathbf{X}}\right), \tag{6}$$

$$\lambda = \lambda_w + \lambda_o \tag{7}$$

represents the total mobility. The term $f_w = \dfrac{\lambda_w}{\lambda}$ represents the fractional flow of water phase. The sequential formulation may be used to construct and solve the hyperbolic equations for the saturations (similar to Equation(4)) and elliptic (or parabolic) equation for the pressure (similar to Equation (5)). Unfortunately, the sequential strategies become inefficient when the flow and transport equations are strongly coupled. Examples of these cases include compositional displacements, and processes with strong capillarity effects.

To extend the applicability of the multiscale methods for these challenging cases, a number of methods for modeling strongly coupled nonlinear mixed hyperbolic / parabolic (elliptic) system are proposed in this disclosure:

(a) Multilevel Constrained Pressure Residual Galerkin Multiscale (ML-CPR-GMS) when $\mathbf{R} = \mathbf{P}^T$ ;
(b) Multilevel Constrained Pressure Residual Non-Galerkin Multiscale (ML-CPR-NGMS) when $\mathbf{R} \neq \mathbf{P}^T$,
(c) Monotone Multilevel Constrained Pressure Residual Galerkin Multiscale (MML-CPR-GMS) when $A_g \neq A_c = \mathbf{P}^T A \mathbf{P}$ (where $A_c$ and $A_g$ are the original and monotone coarse level pressure operators respectively),
(d) Monotone Multilevel Constrained Pressure Residual Non-Galerking Multiscale (MML-CPR-NGMS) when $A_g \neq A_c = \mathbf{R} A \mathbf{P}$.

According to some embodiments, a user may choose from among the four aforementioned methods to obtain a solution for a particular physical situation. In these methods, the CPR strategy may be used to formulate the pressure linear system of equations, the approximate conservative solution of which is obtained by employing a few iterations of the multi-level multiscale procedure. According to some embodiments, any of several local (by way of non-limiting example, ILU(k), BILU(k), Gauss-Seidel, etc.) smoothers combined with the global-stage (by way of non-limiting example, Multiscale Finite Volume, MsFV, and/or Multiscale Finite Element, MsFE, and/or Multiscale Restriction Smoothed Basis, MsRSB, etc.) multiscale procedure with different localization conditions (by way of non-limiting example, Linear BC, Reduced Problem BC, etc.) for basis functions may be employed in order to find an optimum strategy for the highly nonlinear compositional displacements.

*A Constrained Pressure Residual Multiscale (CPR-MS)*

In general, sequential formulation is less stable compared to a fully implicit CPR reduced system for strongly coupled nonlinear mixed hyperbolic / parabolic (elliptic) systems. The following approach may be used in reservoir simulations according to some embodiments.

(1) To avoid instabilities during the compositional multi-phase / multi-component flow (e.g., some flips in the cell phase state), both mechanical and chemical equilibrium may be used for convergence purpose. Hence, some embodiments perform smoothing action (e.g., at the fine scale).
(2) The pressure equation may be formed using the CPR method. Assuming that for each time step an embodiment solves the following set of non-linear equations constructing using IMPES, IMPSAT or FULLIMP discretization methods, then

$$R_r\left(X_r, X_f\right) = 0$$
$$R_f\left(X_r, X_f\right) = 0 \quad , \tag{8}$$

where $R_r$, $R_f$, $X_r$ and $X_f$ are the reservoir and flash residuals and variables, respectively. The Newton-Raphson method can be used to solve Equation (8). This leads to the following system of equations at iteration $i$, by way of non-limiting example:

$$\begin{pmatrix} \dfrac{\partial R_r}{\partial X_r} & \dfrac{\partial R_r}{\partial X_f} \\[3mm] \dfrac{\partial R_f}{\partial X_r} & \dfrac{\partial R_f}{\partial X_f} \end{pmatrix}\Bigg|_{X_r^i, X_f^i} \begin{pmatrix} \Delta X_r \\ \Delta X_f \end{pmatrix} = -\begin{pmatrix} R_r \\ R_f \end{pmatrix}\Bigg|_{X_r^i, X_f^i} \tag{9}$$

The number of Newton-Raphson iterations can be reduced further by solving the flash equations (Gibbs relations) before solving the fully coupled system. In some embodiments, for each Newton-Raphson iteration $i$, the following may be iteratively solved:

$$\left(\dfrac{\partial R_f}{\partial X_f}\right)\Bigg|_{X_r^i, X_f^i} \left(\Delta X_f\right) = -\left(R_f\right)\Big|_{X_r^i, X_f^i} \tag{10}$$

until $\overline{X}_f$ is found such that $R_f\left(X_r^i, \overline{X}_f\right) = 0$.

This reduces Equation (9) to, by way of non-limiting example:

$$\begin{pmatrix} \dfrac{\partial R_r}{\partial X_r} & \dfrac{\partial R_r}{\partial X_f} \\[3mm] \dfrac{\partial R_f}{\partial X_r} & \dfrac{\partial R_f}{\partial X_f} \end{pmatrix}\Bigg|_{X_r^i, \overline{X}_f} \begin{pmatrix} \Delta X_r \\ \Delta X_f \end{pmatrix} = -\begin{pmatrix} R_r \\ 0 \end{pmatrix}\Bigg|_{X_r^i, \overline{X}_f} \tag{11}$$

The variables $\Delta X_f$ may be eliminated by Schur complement action (it is cheap and localized):

$$\begin{pmatrix} \dfrac{\partial R_r}{\partial X_r} - \dfrac{\partial R_r}{\partial X_f}\left(\dfrac{\partial R_f}{\partial X_f}\right)^{-1}\dfrac{\partial R_f}{\partial X_r} & 0 \\[3mm] \dfrac{\partial R_f}{\partial X_r} & \dfrac{\partial R_f}{\partial X_f} \end{pmatrix}\Bigg|_{X_r^i, \overline{X}_f} \begin{pmatrix} \Delta X_r \\ \Delta X_f \end{pmatrix} = -\begin{pmatrix} R_r \\ 0 \end{pmatrix}\Bigg|_{X_r^i, \overline{X}_f} \tag{12}$$

The resulting reservoir matrix may be further analysed before applying multiscale method:

$$\left(\dfrac{\partial R_r}{\partial X_r} - \dfrac{\partial R_r}{\partial X_f}\left(\dfrac{\partial R_f}{\partial X_f}\right)^{-1}\dfrac{\partial R_f}{\partial X_r}\right)\Bigg|_{X_r^i, \overline{X}_f} \left(\Delta X_r\right) = \mathbf{A}\cdot\left(\Delta X_r\right) = -\left(R_r\right)\Big|_{X_r^i, \overline{X}_f} \tag{13}$$

$$\mathbf{A} = \left( \frac{\partial R_r}{\partial X_r} - \frac{\partial R_r}{\partial X_f} \left( \frac{\partial R_f}{\partial X_f} \right)^{-1} \frac{\partial R_f}{\partial X_r} \right)\Bigg|_{X_r^i, \bar{X}_f} = \left( \begin{matrix} \mathbf{A}_{pp} & \mathbf{A}_{ps} \\ \mathbf{A}_{sp} & \mathbf{A}_{ss} \end{matrix} \right)\Bigg|_{x_p^i, x_s^i, \bar{X}_f} \tag{14}$$

Reservoir variables (physical parameters) may be generally a combination of pressure, phase saturations and some of the phase specific molar fractions, i.e., $X_r = \left( p, S_\alpha, x_i^\alpha \right)$. For different time discretization schemes (IMPES, IMPSAT, FULLIMP), the resulting reservoir matrix A can contain some coupling terms between $x_p = (p)$ and $x_s = \left( S_\alpha, x_i^\alpha \right)$ in the matrix **A**. Additional reduction actions (e.g., constrained pressure residuals) can be performed to obtain only parabolic (or elliptic) pressure equation. According to some embodiments, the first action in CPR is to apply an IMPES-like reduction to Equations (13-14) in which both sides of Equation (13) are multiplied by a matrix of the form, by way of non-limiting example:

$$\mathbf{M} = \begin{bmatrix} \mathbf{I} & -\mathbf{Q} \\ 0 & \mathbf{I} \end{bmatrix} \tag{15}$$

where $\mathbf{A}_{pp}^*$ is defined as, by way of non-limiting example:

$$\mathbf{A}_{pp}^* = \mathbf{A}_{pp} - \mathbf{Q}\mathbf{A}_{sp}, \ \ \mathbf{A}_{ps}^* = \mathbf{A}_{ps} - \mathbf{Q}\mathbf{A}_{ss}, \ \ R_p^* = R_p - \mathbf{Q}R_s, \tag{16}$$

$$\mathbf{Q} = \text{approx}(\mathbf{A}_{ps} \cdot \mathbf{A}_{ss}^{-1}) = \text{colsum}\left( \mathbf{A}_{ps} \right) \text{colsum}\left( \mathbf{A}_{ss} \right)^{-1} \tag{17}$$

$$\left( \Delta X_r \right) = \begin{pmatrix} \Delta x_p \\ \Delta x_s \end{pmatrix} \tag{18}$$

to obtain

$$\left( \begin{matrix} \mathbf{A}_{pp}^* & \mathbf{A}_{ps}^* \\ \mathbf{A}_{sp} & \mathbf{A}_{ss} \end{matrix} \right)\Bigg|_{x_p^i, x_s^i, \bar{X}_f} \begin{pmatrix} \Delta x_p \\ \Delta x_s \end{pmatrix} = -\left( \begin{matrix} R_p^* \\ R_s \end{matrix} \right)\Bigg|_{x_p^i, x_s^i, \bar{X}_f}, \ \ \Delta x_p = x_p^{i+1} - x_p^i. \tag{19}$$

Now the pressure matrix may be extracted as follows, by way of non-limiting example:

$$\mathbf{A}_{pp}^* = \mathbf{C}^{\mathbf{T}}\mathbf{M}\mathbf{A}\mathbf{C} \tag{20}$$

where

$$\mathbf{C}^T = \begin{bmatrix} \mathbf{I} & 0 \end{bmatrix}.$$

The effectiveness of the CPR methods can depend on the quality of the pressure matrix $\mathbf{A}_{pp}^* = \mathbf{C}^{\mathbf{T}}\mathbf{M}\mathbf{A}\mathbf{C}$.

Several methods may be used to produce $\mathbf{A}_{pp}^{*}$, by way of non-limiting example:

    (a) Quasi-IMPES
    (b) True-IMPES.

In certain embodiments, for Quasi-IMPES scheme, off-diagonal $\mathbf{A}_{ps}$ terms can be ignored and the diagonal $\mathbf{A}_{ps}$ part eliminated using the inverse of the block-diagonal of $\mathbf{A}$.

The resulting pressure matrix $\mathbf{A}_{pp}^{*}$ may be solved with multiscale method as follows. The basic idea of the conventional multi-scale method includes approximating the fine scale pressure in a dual coarse grid with a number of wells as:

$$p^k\left(\xi\right) \approx \phi^{k,m}\left(\xi\right) + \sum_{i=1}^{M} \overline{p}_i^k \phi_i^{k,m}\left(\xi\right) + \sum_{s=1}^{W} p_{well,s}^{k,ref} \phi_{well,s}^{k,m}\left(\xi\right) \tag{21}$$

where the basis functions $\phi_i^{k,m}\left(\xi\right)$ (which potentially could change from iteration to iteration) and correction function $\phi^{k,m}(\xi)$ (which potentially could change from iteration to iteration) and well functions $\phi_{well,s}^{k,m}\left(\xi\right)$ are numerical solutions of localized boundary value problem, $p^k(\xi)$ is the $k^{th}$-iteration reservoir pressure during Newton-Raphson method, $p_{well,s}^{k,ref}$ is the $k^{th}$ iteration well pressure during Newton-Raphson method. Substituting Eq.(21) into Eq.(13), it follows

$$p^{k+1}\left(\xi\right) - p^k\left(\xi\right) \approx \left[\phi^{k+1,m}\left(\xi\right) - \phi^{k,m}\left(\xi\right)\right] + \sum_{i=1}^{M}\left(\frac{\partial p^k\left(\xi\right)}{\partial \overline{p}_i}\right)\Delta\overline{p}_i^k + \sum_{s=1}^{W}\left(\frac{\partial p^k\left(\xi\right)}{\partial p_{well,s}^{k,ref}}\right)\Delta p_{well,s}^{k,ref} \tag{21'}$$

$$\left[\left(\frac{\partial p^k\left(\xi\right)}{\partial \overline{p}_i}\right)^T \left[\mathbf{A}_{pp}^{*}\right]_{\tilde{x}_p^j, x_s^j, \overline{X}_f}\left(\frac{\partial p^k\left(\xi\right)}{\partial \overline{p}_i}\right)\right]\left(\overline{p}^{k+1}\left(\xi\right) - \overline{p}^k\left(\xi\right)\right) =$$
$$-\left(\frac{\partial p^k\left(\xi\right)}{\partial \overline{p}_i}\right)^T\left(R_p^{*}\Big|_{\tilde{x}_p^j, x_s^j, \overline{X}_f} + \left[\mathbf{A}_{pp}^{*}\right]_{\tilde{x}_p^j, x_s^j, \overline{X}_f}\left[\phi^{k+1,m}\left(\xi\right) - \phi^{k,m}\left(\xi\right)\right] + \left[\mathbf{A}_{pp}^{*}\right]_{\tilde{x}_p^j, x_s^j, \overline{X}_f}\left(\frac{\partial p^k\left(\xi\right)}{\partial p_{well,s}^{ref}}\right)\Delta p_{well,s}^{ref}\right) \tag{22}$$

$$\tilde{x}_p^i = \phi^{k,m}\left(\xi\right) + \sum_{i=1}^{M} \overline{p}_i^k \phi_i^{k,m}\left(\xi\right) + \sum_{s=1}^{W} p_{well,s}^{k,ref} \phi_{well,s}^{k,m}\left(\xi\right) \tag{23}$$

The system of Equation (22) may be re-written in the compact form as follows

$$\left(\left[\mathbf{P}\right]^T\left[\mathbf{A}_{pp}^{*}\right]\left[\mathbf{P}\right]\right)\cdot\delta p = \left[\mathbf{A}_{pp}^{**}\right]\cdot\delta p = \tilde{\mathbf{R}} \tag{24}$$

where

$$\left[\mathbf{P}\right] = \left(\frac{\partial p^k\left(\xi\right)}{\partial \overline{p}_i}\right) \text{ is the prolongation operator} \tag{25}$$

$$\delta p = \overline{p}^{k+1}(\xi) - \overline{p}^{k}(\xi), \tag{26}$$

$$\tilde{\mathbf{R}} = -\left(\frac{\partial p^{k}(\xi)}{\partial \overline{p}_{i}}\right)^{T}\left(R_{p}^{*}\Big|_{\tilde{x}_{p}^{j},x_{s}^{j},\overline{X}_{f}} + \left[A_{pp}^{*}\right]_{\tilde{x}_{p}^{j},x_{s}^{j},\overline{X}_{f}}\left[\phi^{k+1,m}(\xi) - \phi^{k,m}(\xi)\right] + \left[A_{pp}^{*}\right]_{\tilde{x}_{p}^{j},x_{s}^{j},\overline{X}_{f}}\left(\frac{\partial p^{k}(\xi)}{\partial p_{well,s}^{ref}}\right)\Delta p_{well,s}^{ref}\right), \tag{27}$$

$$\left[A_{pp}^{**}\right] = \left[\mathbf{P}\right]^{T}\left[A_{pp}^{*}\right]\left[\mathbf{P}\right] \text{ is the coarse multiscale matrix.} \tag{28}$$

The prolongation operator [P] may be constructed using different multiscale basis function, which can be obtained using (by way of non-limiting example) either Finite Volume or Finite Element Methods with different boundary conditions on the dual mesh or Restriction Smoothed Basis, or Meshless Basis Functions. The coarse pressure system Equation (24) can be solved exactly using different solver techniques (by way of non-limiting example, super ILU, AMG, etc.) or approximately using **one V** cycle of the AMG. After obtaining the pressure update $\delta p$, the pressure field at the fine scale may be reconstructed using prolongation operator:

$$\tilde{p}^{k+1}(\xi) \approx \phi^{k+1,m}(\xi) + \sum_{i=1}^{M}\overline{p}_{i}^{k+1}\phi_{i}^{k+1,m}(\xi) + \sum_{s=1}^{W}p_{well,s}^{k+1,ref}\phi_{well,s}^{k+1,m}(\xi), \quad \overline{p}^{k+1}(\xi) = \overline{p}^{k}(\xi) + \delta p \tag{29}$$

Alternately, the coarse level pressure equation can be derived using conservative restriction operator [R] as

$$\left(\left[\mathbf{R}\right]\left[A_{pp}^{*}\right]\left[\mathbf{P}\right]\right)\cdot\delta p = \left[A_{pp}^{**}\right]\cdot\delta p = \tilde{\mathbf{R}} \text{ where in general we have } [\mathbf{R}] \neq [\mathbf{P}].$$

The method outlined above may include having starting points $\overline{p}_{i}^{k=0}$, $\phi^{k=0,m}$, $\phi_{i}^{k=0,m}$, $p_{well,s}^{k=0,ref}$, $\phi_{well,s}^{k=0,m}$.

The basis functions $\phi^{k=0,m}$, $\phi_{i}^{k=0,m}$, $p_{well,s}^{k=0,ref}$, $\phi_{well,s}^{k=0,m}$ can be computed by solving localized boundary value problem.

The values $\overline{p}_{i}^{k=0}$ and $p_{well,s}^{k=0,ref}$ can be computed by taking $\overline{p}_{i}^{k=0} = p^{k=0}(\xi)$ at the cells where two grids (fine and coarse) are collocated or by solving linear set of equations (in case if coarse and fine grid are not collocated):

$$\int_{\Omega}p^{k=0}(\xi)\phi_{j}^{k,m}(\xi)d\xi =$$

$$\int_{\Omega}\phi_{j}^{k,m}(\xi)\phi^{k,m}(\xi)d\xi + \sum_{i=1}^{M}\overline{p}_{i}^{k}\int_{\Omega}\phi_{j}^{k,m}(\xi)\phi_{i}^{k,m}(\xi)d\xi + \sum_{s=1}^{W}p_{well,s}^{k,ref}\int_{\Omega}\phi_{well,s}^{k,m}(\xi)\phi_{j}^{k,m}(\xi)d\xi \tag{30}$$

$$\int_{\Omega}p_{well}^{k=0,ref}(\xi)\phi_{well,j}^{k,m}(\xi)d\xi =$$

$$\int_{\Omega}\phi_{well,j}^{k,m}(\xi)\phi^{k,m}(\xi)d\xi + \sum_{i=1}^{M}\overline{p}_{i}^{k}\int_{\Omega}\phi_{well,j}^{k,m}(\xi)\phi_{i}^{k,m}(\xi)d\xi + \sum_{s=1}^{W}p_{well,s}^{k,ref}\int_{\Omega}\phi_{well,s}^{k,m}(\xi)\phi_{well,j}^{k,m}(\xi)d\xi \tag{31}$$

After solving the pressure equation Equations (15-16), the remaining variables (i.e., saturations and molar fractions) can be recovered from Equations (5-11). It may not be required in the case of FULLIMP, IMPSAT to construct the total velocity field to compute hyperbolic variables.

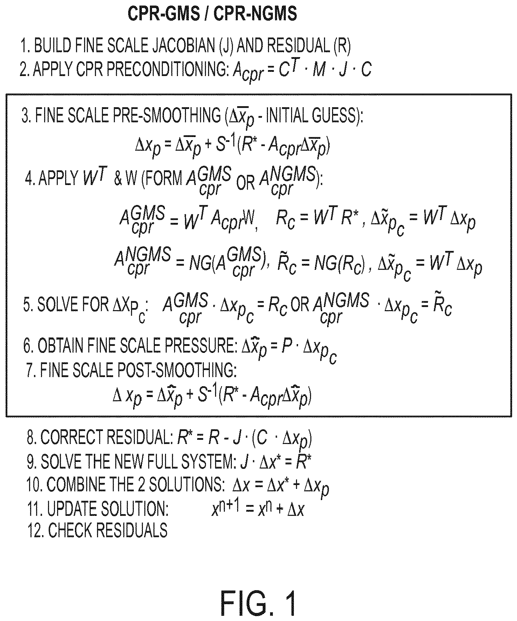

Fig. 1 illustrates an example partial set of actions for performing constrained proposed pressure residual Galerkin multiscale (CPR-GMS) and constrained pressure residual non-Galerkin multiscale (CPR-NGMS) methods. In some embodiments, actions 1-2 and 8-12 can be the same as these shown in the original CPR-type. Actions 3 and 4 can utilize advantages of the multiscale technology as described herein. In a case of monotone method (e.g., MML-CPR-NGMS and MML-CPR-GMS) an algorithm can be applied to obtain final coarse level pressure. Basis functions, needed for the construction of MS restriction **[R]** and prolongation **[P]** operators, can be computed at the beginning of each time step or at the beginning of the simulation and kept constant throughout the Newton-Raphson loop or simulation respectively. In addition, the update of basis functions can be done adaptively in some parts of the reservoir. Updating them at the end of each Newton-Raphson iteration may be useful when large time step sizes are used. The coarse system can be solved (action 5) with any of a number of various different strategies.

The choice of the solver for the coarse pressure system may be related to the size of the coarse pressure matrix. This may depend both on the size of the model and on the choice of the coarsening factors. If the size of the coarse system is small enough, a direct solver can be used. For large cases, in order to obtain a small coarse pressure matrix, very large coarsening factors may be used. This may slow down the computation of basis functions as a direct solver is usually used for this action. In order to avoid this slow down, an iterative method may be used for the basis functions computation; in certain embodiments, this occurs at the beginning of the simulation process. Increasing the coarsening factors too much may affect the accuracy of the pressure solution and the number of nonlinear iterations.

Following the structure of multigrid solver techniques, pre- and post-smoothing actions on the fine scale pressure solution may be introduced. The fine scale pressure solution may be smoothed using, by way of non-limiting example, either Gauss-Seidel (GS) or ILU(0).

*Particular Case (Black Oil)*

The above can be applied in the case of a reservoir containing miscible three phase black oil. For example, using IMPES formulation, the pressure equations may be solved assuming only $S_W$ and $S_G$ are fixed. In some embodiments, a coupled system for pressure may be formed (e.g., using $p_G$ and $R_s$ for GasWater cell state); see Equation (2). The variables $R_s$ may be eliminated by using a Schur complement (it is inexpensive and localized); see Equation (5). The resulting pressure Equations (15-16) matrix may be solved with a multiscale method, and then $R_s$ may be updated together with $b_G$ and $b_O$. By doing this operation, the pressure equation (mechanical equilibrium) may feel the changes in the chemical equilibrium and vice versa. This operation is called second stage reduction in the prior art INTERSECT® simulator and it is generally not that expensive. The velocity may be computed using updated variable $R_s$, $p_G$, $b_O$, and $b_G$. The rest of computations may be the same as in the conventional prior art INTERSECT® multiscale implementation.

## II. Reservoir Modeling: A Second Perspective

This section describes a Multiscale (MS) method for fully implicit simulations of multiphase flow in highly heterogeneous porous media. From a fully implicit Jacobian, a Constrained Pressure Residual (CPR) preconditioning method is used to extract the pressure system. This pressure system is then coupled with a second stage solver for the full residual correction, as it is done in the classical CPR-based fully implicit solvers. Among other innovations, some embodiments employ MsFEM or MsFVM or MsRBS to obtain an approximate solution of the CPR-based pressure system. More precisely, the global solver may be based on a multiscale coarse-scale system (MsFVM or MsFEM or MsRBS), before and after which pre- and post-smoothing may be applied on the fine scale solution in order to eliminate high-frequency errors. This multi-stage multiscale strategy combines the advantages of multiscale methods with the stability of fully implicit systems for highly coupled problems. As such, being integrated in the fully implicit iterative procedure, the CPR-MS captures the strong nonlinear coupling terms efficiently.

*CPR-based Fully Implicit Reservoir Simulation*

Mathematical formulation of multi-component/multi-phase fluid flow in hydrocarbons reservoirs leads to nonlinear coupled system of partial differential equations (PDEs). To solve the strongly nonlinear and coupled system of discretized equations, arising from the spatial and temporal discretization of the governing equations, a global linearization Newton-Raphson method may be used. This global linearization can result in sparse large linear systems of equations, by way of non-limiting example, represented as follows.

$$J\Delta X = \begin{bmatrix} J_{pp} & J_{ps} \\ J_{sp} & J_{ss} \end{bmatrix} \begin{bmatrix} \Delta x_p \\ \Delta x_s \end{bmatrix} = r = \begin{bmatrix} r_p \\ r_s \end{bmatrix} \tag{32}$$

In Equation (32), Jpp is the pressure block coefficients, $J_{ss}$ is the non-pressure block (saturations or components molar fractions) coefficients, $J_{ps}$ and $J_{sp}$ represent the respective coupling coefficients. The terms $\Delta x_p$ and $\Delta x_s$ represent the increments of pressure (primary variables or physical parameters) and of the other (secondary) variables or physical parameters (e.g., saturations and components molar fractions). In many practical scenarios the linear solver action represents a dominant part of the whole computational time. Performance of iterative linear solvers strongly depends on robust and fast preconditioners, amenable for massive parallelization. Additionally, for realistic-scale problems, the memory requirement to store the sparse Jacobian linear systems becomes an important consideration.

Linear solvers generally used in reservoir simulations consist of preconditioned Krylov subspace methods such as ORTHOMIN with nested factorization as a preconditioner. A significant improvement in preconditioning strategy of linear systems arising from reservoir simulations was made by introducing the Constrained Pressure Residual preconditioning (CPR) method. The CPR preconditioner acknowledges the fact that Equation (32) is of a mixed parabolic (or elliptic)-hyperbolic type. By targeting the parabolic part of the system (or elliptic for incompressible flow) as a separate inner stage, the CPR method improves the convergence rate for the full linear system, based on a pressure predictor-corrector strategy for each linear step. The pressure equation may be constructed by an IMPES-like reduction of Equation (32), discussed above, where both sides are multiplied by a matrix of the form (i.e., Schur complement with the matrix $\mathbf{J}_{ss}$):

$$\mathbf{M} = \begin{bmatrix} \mathbf{I} & -\mathbf{Q} \\ \mathbf{0} & \mathbf{I} \end{bmatrix} \tag{33}$$

in order to obtain

$$\begin{bmatrix} \mathbf{J}_{pp}^* & \mathbf{J}_{ps}^* \\ \mathbf{J}_{sp} & \mathbf{J}_{ss} \end{bmatrix} \begin{bmatrix} \Delta x_p \\ \Delta x_s \end{bmatrix} = \begin{bmatrix} r_p^* \\ r_s \end{bmatrix}, \tag{34}$$

where

$$\mathbf{J}_{pp}^* = \mathbf{J}_{pp} - \mathbf{Q}\mathbf{J}_{sp},$$

$$\mathbf{J}_{ps}^* = \mathbf{J}_{ps} - \mathbf{Q}\mathbf{J}_{ss},$$

and

$$\mathrm{r}_p^* = \mathrm{r}_p - \mathbf{Q}\mathrm{r}_s.$$

In order to simplify the Schur complement procedure, it is assumed that

$$\mathbf{Q} = \mathbf{J}_{ps}\mathbf{J}_{ss}^{-1} \approx Q \cdot \mathbf{I}, \text{with} = colsum(\mathbf{J}_{ps}) \cdot colsum(\mathbf{J}_{ss})^{-1}, \tag{35}$$

where matrices $\mathbf{J}_{ps}$ and $\mathbf{J}_{ss}$ are replaced by vectors whose elements are the sums of each column. This implies that $\mathbf{J}_{ps}^*$ is approximately equal to zero, i.e.,

$$\mathbf{J}_{pp}^* \Delta x_p \approx r_p^* \tag{36}$$

or that the pressure matrix can be extracted as follows

$$\mathbf{J}_{pp}^* = \mathbf{C}^T \mathbf{M} \mathbf{J} \mathbf{C}, \mathbf{C}^T = \begin{bmatrix} \mathbf{I} & \mathbf{0} \end{bmatrix}. \tag{37}$$

The effectiveness of CPR methods depends, to a large extent, on the quality of the pressure matrix $\mathbf{J}_{pp}^* = \mathbf{C}^T \mathbf{M} \mathbf{J} \mathbf{C}$. Several methods can be used to extract $\mathbf{J}_{pp}^*$, such as:

- Quasi-IMPES
- True-IMPES

For Quasi-IMPES scheme, some embodiments ignore the off-diagonal $\mathbf{J}_{ps}$ terms and eliminate the diagonal

part of $\mathbf{J}_{ps}$ using the inverse of the block-diagonal of $\mathbf{J}_{ss}$.

Equation (36) is the pressure equation. It forms an approximation of the parabolic (or elliptic for incompressible flow) part of the discrete operator and may be considered separately from the remaining hyperbolic part.

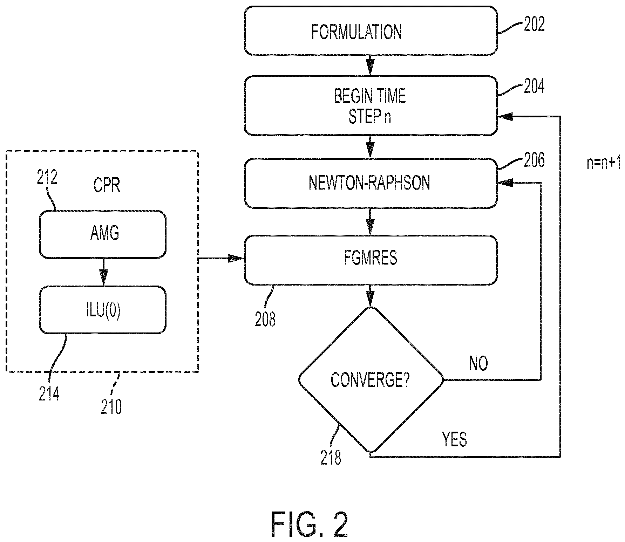

Fig. 2 is a schematic diagram illustrating a method for flexible generalized minimal residual (FGMRES) preconditioned by a two-stage constrained pressure residual preconditioner. The linear system of Equation (32) (formulation 202) may be solved by flexible generalized minimal residual 208 (FGMRES), preconditioned by the CPR method 210. The preconditioner can include two complementary stages. The first stage 212 may be used to approximate the pressure solution by commonly applying Algebraic Multigrid (AMG) method to Equation (36). In the second stage 214, another preconditioner (e.g., the ILU(O) method) may be applied to the full system of Equation (32) such that the first stage pressure approximation is used as the initial guess. Thus, Fig. 2 illustrates the process for a given time step 204, in which is nested a Newton-Raphson loop 206 with attendant convergence detection 218.

A linear solver based on CPR-AMG preconditioning may be effective in terms of algorithmic efficiency. However, there are still challenges to overcome in implementing a near-ideal scalable AMG solver. Also, the second stage of CPR preconditioning often incudes a variant of an incomplete LU factorization, which again is non-trivial to parallelize. As a result, the linear solver is still some way from near-ideal scalability. In what follows, the Constrained Pressure Residual Multiscale (CPR-MS) Solver is described, embodiments of which address some or all of these shortcomings.

*Multiscale Basis Functions*

Analogously to finite element methods, multiscale methods use an approximation space that is spanned by basis functions. Some embodiments use multiscale finite element basis functions to create an approximation space for pressure of much lower dimension than the original simulation grid. The approximation space may be constructed using a discretization for pressure to capture the effect of fine-scale heterogeneity locally.

In the MsFEM, MsFVM and MsRBS methods, the discretization for pressure basis functions may be obtained from sequential formulation. The pressure residual is formed like in IMPES formulation by eliminating the unknown saturation from the mass balance equations. The pressure matrix may be the Jacobian of the pressure residual.

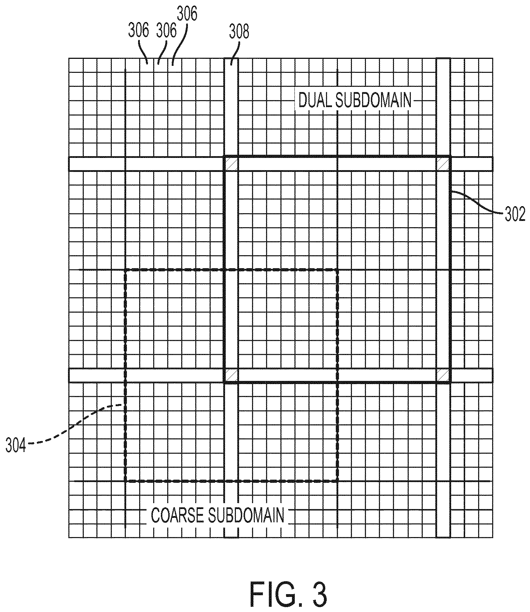

Fig. 3 schematically illustrates a simulation grid with both a fine partition and coarse overlapping subdomains. For the MsFE basis functions, the simulation grid is partitioned into overlapping subdomains 302, where the cells (e.g., 306) in the overlap region 308 form a coarse mesh. The MsFV method uses a non-overlapping partition 304.

Let the dual coarse grid be a partition, $D = \{D_1,...,D_M\}$, of the main grid into $M$ overlapping subdomains such that the overlap yields a discrete 3D mesh: each grid cell is classified as an *inner cell* if it is not part of the overlap between subdomains. The overlapping region between subdomains is partitioned into a set of *face* subdomains that form an overlap only between two partitions, the remaining cells (wirebasket) are partitioned into *edge* subdomains connected by *corner cells* (Jenny et al., 2003).

For each subdomain $D_k$, compute basis functions $\phi_i^k$ for each corner cell $i \in D_k$ with the properties that $\phi_i^k = \delta_{ij}$ for corner cells j. Each basis function $\phi_i^k$ is a discrete solution to a homogeneous pressure equation in the interior of $D_k$ and solves a reduced pressure equation on the face and edge subdomains on the boundary of $D_k$ (Hou and Wu, 1997). The discrete subdomain basis functions created in this way are continuous across subdomain boundaries and we have by construction

$$\sum_{i=1}^n \phi_i^k = 1 \text{ (where n is the number of corners in } D_k), \tag{38}$$

for each subdomain $D_k \in \mathcal{D}$. Thus, the coarse scale approximation space includes constant functions. The following may utilize the multiscale basis functions as an interpolation operator. By collecting all basis functions into a matrix **P,** some embodiments obtain a linear operator that interpolates pressures $x_p^c$ in the wirebasket corner cells to the whole grid.

$$x_p = \mathbf{P} x_p^c. \tag{39}$$

Some embodiments utilize restriction operators **R** to form a linear system for the pressure in the wirebasket corner cells. Two different restriction operators may be used, by way of non-limiting example. One is to use $\mathbf{R_{FE}} = \mathbf{P^T}$. The application of $\mathbf{R_{FE}}$ to a vector $x$ yields a weighted sum of x for cells near each wirebasket corner cell. Applied to a linear system, it yields a classical Galerkin type coarse scale approximation.

The other useful restriction operator is a finite-volume type restriction $\mathbf{R_{FV}}$. For a nonoverlapping decomposition

$\{\Omega_1,...,\Omega_N\}$ of the simulation grid, dual to $\mathcal{D}$ in the sense that each subdomain $\Omega_i$ contains one (and only one) wirebasket corner cell, the **R$_{FV}$** may be defined by

$$(R_{FV})_{ij} = \begin{cases} 1 & \text{if cell } j \in \Omega_i, \\ 0 & \text{otherwise.} \end{cases} \tag{40}$$

*Constrained Pressure Residual Multiscale (CPR-MS) Solver*

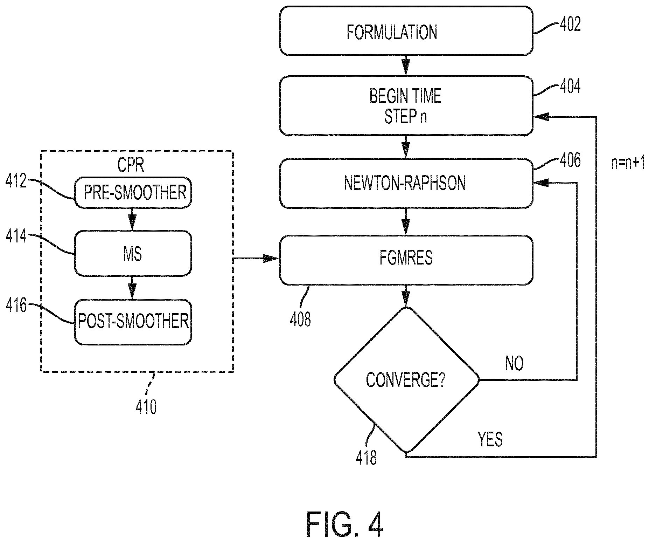

Fig. 4 is a schematic diagram illustrating constrained proposed pressure residual Galerkin multiscale (CPR-GMS) and constrained pressure residual non-Galerkin multiscale (CPR-NGMS) methods. Blocks 402, 404, 406, 408, and 418 are essentially the same as blocks 202, 204, 206, 208 and 218 of Fig. 2.

Regarding blocks 410, 412, 414, and 416 of Fig. 4, the CPR-MS algorithm combines both actions of the CPR-AMG method and of multiscale methods. In fact, a fully implicit system may be solved with a CPR type 2-stage preconditioners where a MS method is used for solving the pressure system extracted by the CPR decoupling operator. Starting from the Jacobian matrix **J** built with a fully implicit formulation, the whole solution strategy can be summarized as follows (the below actions are referred to herein as the "Example Process Summary").

1. CPR preconditioning: the pressure matrix is extracted $\mathbf{A}_{cpr} = \mathbf{C}^T\mathbf{MJC}$ and the residual is restricted to a pressure residual $r_p = \mathbf{C}^T r$. (This action may correspond to action 2 of Fig. 1.)

2. Construction of the coarse pressure system using Restriction **(R)** and Prolongation **(P)** operators built with the basis functions computed either with a finite element or finite volume multiscale method: $\mathbf{A}_{cpr}^M = \mathbf{R A}_{cpr}\,\mathbf{P}$ and $r_p^M = \mathbf{R} \cdot r_p$. (This roughly corresponds to action 4 of Fig. 1.)

3. The coarse pressure system is solved and its solution is prolongated to the fine scale: $\mathbf{A}_{cpr}^M \cdot \Delta x_p^c = r_p^M$ and $\Delta x_p = \mathbf{P} \cdot \Delta x_p^c$. (Note that the term **P** here corresponds to **W** of Fig. 1.)

4. The full system residual is corrected using the fine scale solution: $r^* = r \cdot \mathbf{J} \cdot (\mathbf{C} \cdot \Delta x_p)$. (This corresponds to action 8 of Fig. 1.)

5. The corrected full system is solved with a second stage preconditioner: $\Delta x^* = \mathbf{M}^{-1} \cdot r^*$. (This corresponds to action 9 of Fig. 1.)

6. The two solutions are combined in order to build the full system solution: $\Delta x = \Delta x^* + \mathbf{C} \cdot \Delta x_p$. (This corresponds to action 10 of Fig. 1.)

Actions 1, 5 and 6 of the Example Process Summary may be performed as in the original CPR-type solver implemented in INTERSECT. Actions 2 and 3 may be performed as in typical multiscale methods (block 414 of Fig. 4). Thus, the original two-stage preconditioning structure of the solution strategy may be altered to utilize a different choice for the solution of the pressure system.

Basis functions, used for the construction of MS restriction **(R)** and prolongation **(P)** operators, may be computed at the beginning of each time step and kept constant throughout the Newton-Raphson loop. Updating them at the end of each Newton-Raphson iteration may be useful when large time step sizes are used.

The coarse system can be solved (action 3 of the above Example Process Summary) with different strategies. The choice of the solver for the coarse pressure system is strictly related to the size of the coarse pressure matrix; this depends both on the size of the model and on the choice of the coarsening factors. If the size of the coarse system is small enough a direct solver can be used; for big cases, in order to obtain a small coarse pressure matrix, very large coarsening factors may be used. This may slow down the computation of basis functions because a direct solver is usually used for this action; in order to avoid this slow down, an iterative method may be used for the basis functions computation. The advantage of doing that is that basis functions calculation is only done once per each time step, whereas a different coarse system may be solved for each Newton iteration. However, increasing too much the coarsening factors may affect the accuracy of our pressure solution and the number of nonlinear iterations may grow.

Following the structure of a multigrid solver, pre- and post-smoothing actions (blocks 412 and 416, respectively) on the fine scale pressure solution are depicted in the above summary. The fine scale pressure solution is smoothed using either Gauss Seidel (GS) or ILU(0) before and after action 3 of the above Example Process Summary.

*Example Application of the Disclosed Techniques*

Tests were carried out on the test case SPE9; it is a 3-phase (water, gas and oil) black oil case without any capillary effect.

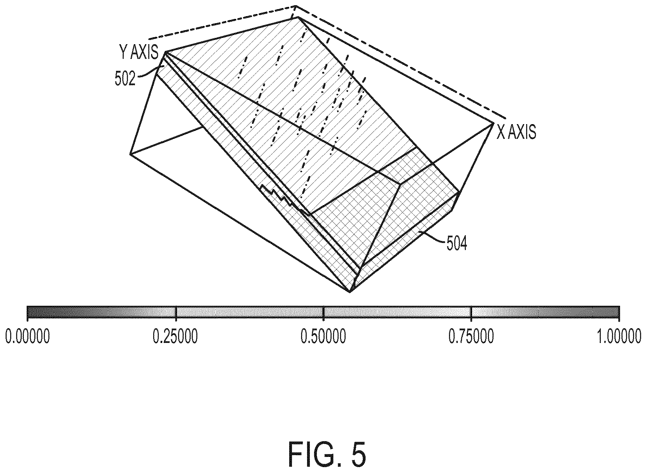

Fig. 5 illustrates an example reservoir representation depicting a fine grid of 648,000 cells. That is, Fig. 5 depicts a fine grid utilized for the test case. The grid 502 was $144 \times 150 \times 30$, for a total of 648,000 cells.

Results and performance were compared with the current version of the INTERSECT® (IX) simulator, which uses CPR preconditioning with a IV-cycle AMG for solving the pressure system and ILU(0) as a second stage preconditioner. Thus, the solution obtained with the current version of IX was used as a reference. The same second stage preconditioner was used so that the only difference is solution strategy of the pressure system. Two different values for the minimum time step size were used which resulted in two completely different time step selections throughout the simulation. The maximum time step size was always kept the same.

All results presented were obtained in serial runs. The algorithm is highly parallelizable and its potential is even greater for parallel runs.

*Results: First Set of Runs*

For the first set of runs, a minimum time step size of 15 days was used. Finite element (FE) basis functions were used. The coarsening factors for the three directions were (3,5,5), which resulted in a coarse grid of $48 \times 30 \times 6$, for a total of 8,640 cells. With such a size of the coarse pressure matrix, direct methods are very slow. For this reason, no results are presented for runs which use a direct solver on the coarse pressure system.

*Table 1* Settings of all runs for a minimum time step size of 15 days

| Runs | Pre-smoothing | Post-smoothing | Coarse Solver |
|------|---------------|----------------|---------------|
| Run 1 | GS | GS | AMG |
| Run 2 | GS | GS | GMRES-AMG |
| Run 3 | GS | GS | AMG |
| Run 4 | none | GS | AMG |

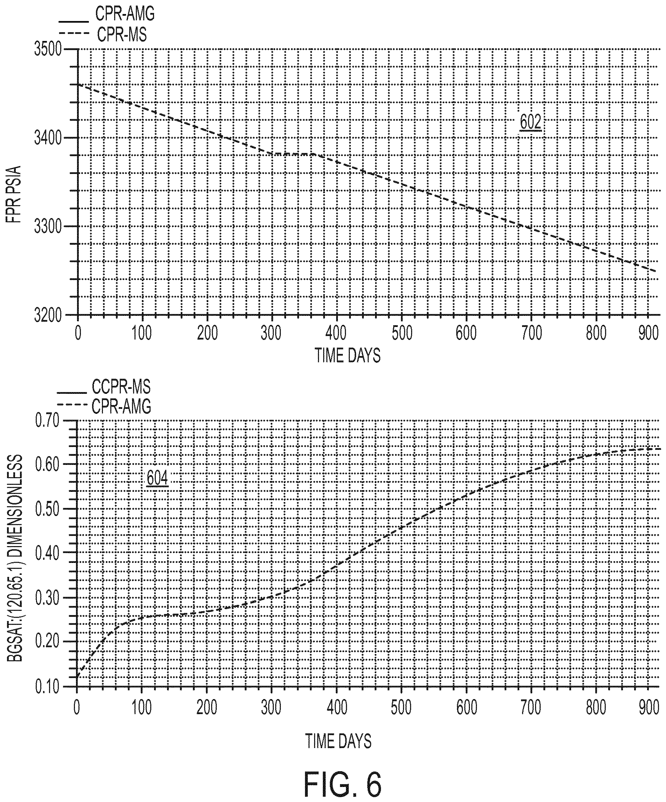

Before proceeding with the analysis of the performance in terms of number of linear iterations and CPU time of the CPR-MS solver, it is important to make sure that the solution does not change. All computed results appeared to be exactly identical to the reference solution, as shown in Fig. 6.

Fig. 6 illustrates graphs depicting field pressure and gas block saturation solutions for CPR-AMG and CPR-MS. Graph 602 depicts average pressure of the entire reservoir. Graph 604 depicts a gas saturation profile of a particular location, (120.65, 1). As depicted in Fig. 6, the two solutions completely match; no exceptions to complete overlap of the curves are visible in Fig. 6, in either graph 602 or 604.

Table 2, below, depicts the results in terms of performance (number of iterations and CPU time) for the four performed runs and for the current INTERSECT configuration (CPR-AMG).

*Table 2* Results of all runs for a minimum time step size of 15 days

| | Number of iterations | | CPU time (s) | |
|------|-----------------|-------------|---------------|-------|
| Runs | Non linear iter. | Linear iter. | Linear Solver | total |
| Run 1 | 369 | 2872 | 1615 | 2699 |
| Run 2 | 369 | 2845 | 1119 | 2203 |
| Run 3 | 371 | 3327 | 1233 | 2309 |
| Run 4 | 371 | 3649 | 2026 | 3114 |
| IX | 369 | 2187 | 1571 | 2537 |

In the test runs, the number of non-linear iterations was almost constant. For Run 3 and Run 4, the heuristic functionality was used; it keeps AMG restriction and prolongation operators constant for a certain number of iterations allowing a speed up of the set-up phase of the AMG solver.

The CPR-MS algorithm uses a greater number of linear iterations than the original Intersect CPR-AMG; this was actually expected as MS methods usually require a great number of linear iterations. Pre and post-smoothing help limiting the growth in the number of linear iterations.

The following table summarizes the relative difference in CPU time between each run and the reference Intersect CPR-AMG run.

**Table 3**

$$\Delta\% = \frac{Time_{run} - Time_{CPR-AMG}}{Time_{CPR-AMG}} \cdot 100$$

| Runs | $\Delta\%$ |
|------|------------|
| Run 1 | +6.38 |
| **Run 2** | **-13.17** |
| **Run 3** | **-8.99** |
| Run 4 | +22.74 |

Comparing the results of Runs 3 and 4, notice that introducing a pre-smoothing reduces considerably the number of linear iterations, and it allows a substantial speedup. Based on these results, using a three-iteration GMRES cycle plus AMG appears to be the most effective choice. If the correct settings are chosen, CPR-MS results to be more than 10% faster than CPR-AMG

*Results: Second Set of Runs*

For the second set of runs a minimum time step size of one day was used. This was the only difference between the two sets of runs. In fact, the same coarsening factors and FE restriction and prolongation operators were used. Heuristic was used for runs 8 and 9.

**Table 4** *Settings of all runs for a minimum time step size of 1 day*

| Runs | Pre-smoothing | Post-smoothing | Course Solver |
|------|---------------|----------------|---------------|
| Run 6 | GS | GS | GMRES-AMG |
| Run 7 | none | GS | AMG |
| Run 8 | none | GS | AMG |
| Run 9 | GS | GS | AMG |

Even for this set of runs, the CPR-MS solver solutions perfectly match the ones provided by Intersect.

**Table 5** *Results of all runs for a minimum time step size of 1 day*

| | Number of iterations | | CPU time (s) | |
|------|------|------|------|------|
| Runs | Non linear iter. | Linear iter. | Linear Solver | total |
| Run 6 | 711 | 4210 | 1718 | 3887 |
| Run 7 | 709 | 4804 | 3301 | 5576 |
| Rung 8 | 708 | 5254 | 1911 | 4085 |
| Run 9 | 709 | 4658 | 3212 | 5472 |
| IX | 706 | 2868 | 2718 | 4666 |

The number of linear iterations for CPR-MS is greater than the one of CPR-AMG. Results for the smaller times step size seem to confirm what was observed for the bigger one.

**Table 6**

$$\Delta\% = \frac{Time_{run} - Time_{CPR-AMG}}{Time_{CPR-AMG}} \cdot 100$$

| Runs | $\Delta\%$ |
|------|------------|
| **Run 6** | **-16.69** |
| Run 7 | +19.5 |
| **Run 8** | **-12.45** |
| Run 9 | +17.27 |

Although, using a pre-smoothing in this case does not seem to be as effective as in the previous one; in fact, by comparing runs 8 and 9, in which the only difference is the presence of the pre-smoother, using a pre-smoother slows down the simulation instead of speeding it up. A GMRES solver preconditioned by AMG appears to be efficient for the coarse pressure system solver in some scenarios.

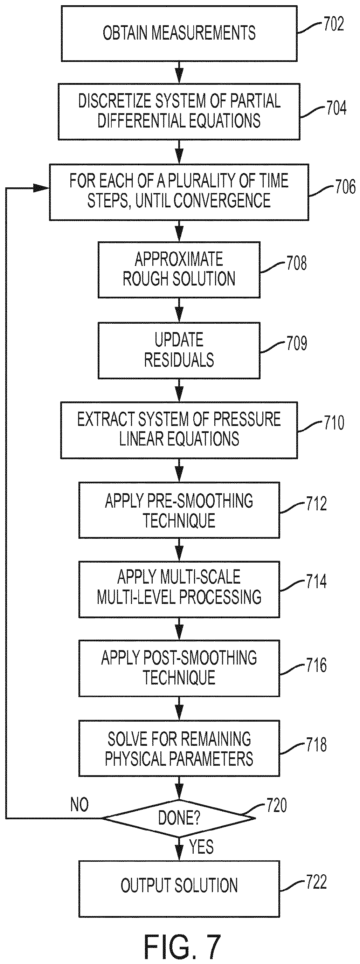

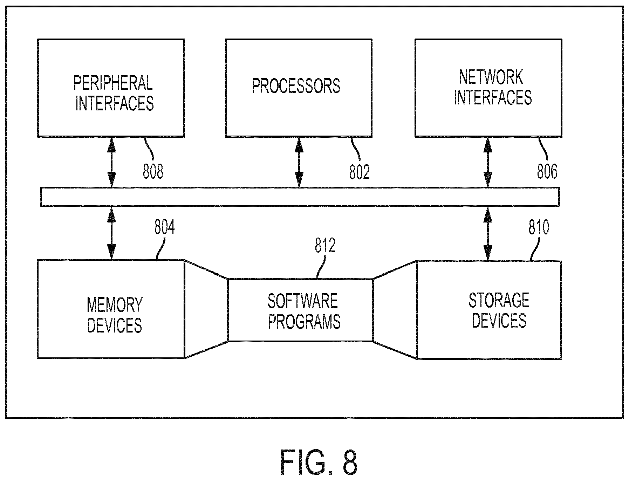

Fig. 7 is a flowchart depicting a method according to some embodiments. The method may be implemented using hardware specialized for parallel processing, such as that described below in reference to Fig. 8. The method may be applied obtain solutions to a linear system of equations arising from the linearization of coupled nonlinear hyperbolic / parabolic (elliptic) partial differential equations (PDEs) of fluid flow in heterogeneous anisotropic porous media. More generally, the method may be applied model the behavior of a petroleum reservoir.

At block 702, the method obtains measurements of physical parameters of the reservoir at various locations within the reservoir and at various times. The number of measurements can range from hundreds to billions. The measured physical parameters can include pressure, phase saturations and phase-specific molar fractions, e.g., as described above in Section I. Various techniques may be utilized to obtain such measurements, such as the use of down-hole sensors.

At block 704, the method discretizes a system of partial differential equations that are formed according to the measurements obtained at block 702. More particularly, the method may form a system of partial differential equations as described above in reference to Equations (1-3) generally, or, more particularly, Equations (4-7). The discretization technique applied to such a system of equations may include, by way of non-limiting example, a finite-volume, second-order state, first-order time technique. More generally, the system of partial differential equations may be discretized using techniques described above in reference to Equation (8).

At block 706, the method establishes one or more nested loops for processing at each of a plurality of time steps and each of a plurality of physical parameter values. Such nested loops are depicted graphically in, and described in reference to, Figs. 2 and 4, for example. The outer loop may iterate per time step, while the inner loop may perform iterations of the Newton-Raphson technique. Each Newton-Raphson iteration may compute a solution to Equation (9) using Equations (10-14), for example.

Note that the processes within the nested loops may be parallelized in computer hardware in order to improve performance. That is, implementations of the invention are particularly suited to execution on parallel processing hardware. To that end, Graphical Processing Units (GPUs) may be used to handle the processing within the nested loops at least partially in parallel.

At block 708, the method approximates a rough solution (initial guess), e.g., to Equation (9) for the time step currently being processed. The technique may utilize a preconditioning process as described herein. The solution from the previous time step may be assumed as initial guess.

At block 709, the method updates the residuals. The actions of this block may be performed as is implicit in action 3 of Fig. 1. (Note that the actions of this block are distinct from action 8 of Fig. 1.)

At block 710, the method extracts a system of linear equations representing pressure. The actions of this block may be performed as described herein in reference to Equations (15-20), action 2 of Fig. 2, block 410 of Fig. 4, and action 1 of the Example Process Summary. More generally, the actions of this block correspond to at least part of the Constrained Pressure Residual (CPR) technique described herein.

At block 712, the method applies a pre-smoothing technique. The actions of this block may be performed as described herein in reference to action 3 of Fig. 1, and block 412 of Fig. 4.

At block 714, the method applies multi-scale multi-level processing. The actions of this block may be performed as described herein in reference to Equations (21-28), action 3 of the Example Process Summary, actions 4-6 of Fig. 1, and block 414 of Fig. 4.

At block 716, the method applies a post-smoothing technique. The actions of this block may be performed as described herein in reference to action 7 of Fig. 1, and block 416 of Fig. 4.

At block 718, having obtained pressure value(s), the method solves for the remaining physical parameters. The actions of this block may be performed as described herein in reference to action 6 of the Example Process Summary, and actions 10 and 11 of Fig. 1.

At block 720, the technique determines whether to repeat the iteration(s) initiated at block 706. This may include determining whether the Newton-Raphson technique has sufficiently converged. The actions of this block may be performed as described herein in reference to action 12 of Fig. 1, and block 418 of Fig. 4.

At block 722, the method outputs the solution. The outputting may take on various forms. The outputting may include displaying a pictorial representation of all or part of the reservoir, displaying one or more graphs depicting one or more physical parameters, delivering data to a separate process (e.g., to determine whether to extract petroleum), or other outputting techniques.

### III. Hardware Technology for Implementations

Fig. 8 illustrates a schematic view of a computing or processor system 800, according to an embodiment. The processor system 800 may include one or more processors 802 of varying core configurations (including multiple cores) and clock frequencies. The one or more processors 802 may be operable to execute instructions, apply logic, etc. It will be appreciated that these functions may be provided by multiple processors or multiple cores on a single chip operating in parallel and/or communicably linked together. In at least one embodiment, the one or more processors 802 may be or include one or more GPUs.

The processor system 800 may also include a memory system, which may be or include one or more memory devices and/or computer-readable media 804 of varying physical dimensions, accessibility, storage capacities, etc. such as flash drives, hard drives, disks, random access memory, etc., for storing data, such as images, files, and program instructions for execution by the processor 802. In an embodiment, the computer-readable media 804 may store instructions that, when executed by the processor 802, are configured to cause the processor system 800 to perform operations. For example, execution of such instructions may cause the processor system 800 to implement one or more portions and/or embodiments of the methods described herein.

The processor system 800 may also include one or more network interfaces 806. The network interfaces 806 may include any hardware, applications, and/or other software. Accordingly, the network interfaces 806 may include Ethernet adapters, wireless transceivers, PCI interfaces, and/or serial network components, for communicating over wired or wireless media using protocols, such as Ethernet, wireless Ethernet, etc.

The processor system 800 may further include one or more peripheral interfaces 808, for communication with a display screen, projector, keyboards, mice, touchpads, sensors, other types of input and/or output peripherals, and/or the like. In some implementations, the components of processor system 800 need not be enclosed within a single enclosure or even located in close proximity to one another, but in other implementations, the components and/or others may be provided in a single enclosure.

The memory device 804 may be physically or logically arranged or configured to store data on one or more storage devices 810. The storage device 810 may include one or more file systems or databases in any suitable format. The storage device 810 may also include one or more software programs 812, which may contain interpretable or executable instructions for performing one or more of the disclosed processes. When requested by the processor 802, one or more of the software programs 812, or a portion thereof, may be loaded from the storage devices 810 to the memory devices 804 for execution by the processor 802.

Those skilled in the art will appreciate that the above-described componentry is merely one example of a hardware configuration, as the processor system 800 may include any type of hardware components, including any necessary accompanying firmware or software, for performing the disclosed implementations. The processor system 800 may also be implemented in part or in whole by electronic circuit components or processors, such as application-specific integrated circuits (ASICs) or field-programmable gate arrays (FPGAs).

The actions described need not be performed in the same sequence discussed or with the same degree of separation. Various actions may be omitted, repeated, combined, or divided, as necessary to achieve the same or similar objectives or enhancements. Accordingly, the present disclosure is not limited to the above-described embodiments, but instead is defined by the appended claims in light of their full scope of equivalents. Further, in the above description and in the below claims, unless specified otherwise, the term "execute" and its variants are to be interpreted as pertaining to any operation of program code or instructions on a device, whether compiled, interpreted, or run using other techniques.

### Claims

1. A computer-implemented method for modeling behavior of at least one fluid in a reservoir, the method comprising:

obtaining a plurality of measurements (702) of a plurality of physical parameters at a plurality of locations within the reservoir, the plurality of physical parameters comprising at least pressure;
discretizing a system of partial differential equations (704) that model, based on the plurality of measurements, the plurality of physical parameters;
iterating, for each of a plurality of time steps, and until convergence (706) upon a solution to the system of partial differential equations, **characterized in that**:

approximating a rough solution (708) to the system of partial differential equations;
applying a constrained pressure residual technique to extract a system of pressure linear equations (710) from the rough solution to the system of partial differential equations;
applying a pre-smoothing technique (712) at a fine scale to determine an approximate solution to the system of pressure linear equations;

applying multi-scale multi-level processing (714) to improve the approximate solution to the system of pressure linear equations;

applying a post-smoothing technique (716) at a fine scale to further improve the approximate solution to the system of pressure linear equations; and

solving the system of partial differential equations for remaining physical parameters (718) based on the further improved approximate solution to the system of pressure linear equations; and

outputting the solution to the system (722) of partial differential equations.

2. The method of claim 1, wherein the outputting comprises displaying a representation of a behavior of the at least one fluid in the reservoir.

3. The method of claim 1, further comprising:

predicting fluid behavior in the reservoir based on the system of partial differential equations; and
extracting fluid from the reservoir based on the predicting.

4. The method of claim 1, wherein the iterating is performed in parallel by at least one hardware graphics processing unit.

5. The method of claim 1, further comprising history matching the system of partial differential equations.

6. The method of claim 1, wherein the physical parameters comprise pressure, flow rate, and composition.

7. The method of claim 1, wherein the reservoir comprises heterogeneous anisotropic porous media.

8. The method of claim 1, wherein at least one of the applying a pre-smoothing technique and the applying a post-smoothing technique comprises applying at least one technique selected from the group consisting of: applying ILU(0), applying a Jacobi smoother, and applying a Gauss-Seidel smoother.

9. A computer system for modeling behavior of at least one fluid in a reservoir, the system comprising at least one electronic processor and persistent memory storing computer-interpretable instructions configured to cause the at least one processor to perform a method comprising:

obtaining a plurality of measurements (702) of a plurality of physical parameters at a plurality of locations within the reservoir, the plurality of physical parameters comprising at least pressure;

discretizing a system of partial differential equations (705) that model, based on the plurality of measurements, the plurality of physical parameters;

iterating, for each of a plurality of time steps, and until convergence (206) upon a solution to the system of partial differential equations, **characterized in that**:

approximating a rough solution (708) to the system of partial differential equations;

applying a constrained pressure residual technique to extract a system of pressure linear equations (710) from the rough solution to the system of partial differential equations;

applying a pre-smoothing technique (714) at a fine scale to determine an approximate solution to the system of pressure linear equations;

applying multi-scale multi-level processing (714) to improve the approximate solution to the system of pressure linear equations;

applying a post-smoothing technique (716) at a fine scale to further improve the approximate solution to the system of pressure linear equations; and

solving the system of partial differential equations for remaining physical parameters (718) based on the further improved approximate solution to the system of pressure linear equations; and

outputting the solution to the system (722) of partial differential equations.

10. The system of claim 9, wherein the outputting comprises displaying a representation of a behavior of the at least one fluid in the reservoir.

11. The system of claim 9, wherein the instructions are further configured to cause the at least one processor to perform:

predicting fluid behavior in the reservoir based on the system of partial differential equations; and
extracting fluid from the reservoir based on the predicting.

12. The system of claim 9 further comprising at least one graphics processing unit, wherein the iterating is performed in parallel by the at least one hardware graphics processing unit.

13. The system of claim 9 wherein the instructions are further configured to cause the at least one processor to perform history matching the system of partial differential equations.

14. The system of claim 9, wherein the physical parameters comprise pressure, flow rate, and composition.

15. The system of claim 9, wherein the reservoir comprises heterogeneous anisotropic porous media.


**Patentansprüche**

1. Computerimplementiertes Verfahren zum Modellieren des Verhaltens von mindestens einem Fluid in einem Reservoir, wobei das Verfahren Folgendes umfasst:

Erlangen einer Mehrzahl von Messungen (702) von einer Mehrzahl von physikalischen Parametern an einer Mehrzahl von Standorten innerhalb des Reservoirs, wobei die Mehrzahl von physikalischen Parametern mindestens Druck umfasst;
Diskretisieren eines Systems von partiellen Differentialgleichungen (704), die auf Grundlage der Mehrzahl von Messungen die Mehrzahl von physikalischen Parametern modellieren;
Wiederholen für jeden einer Mehrzahl von Zeitschritten und bis zur Annäherung (706) an eine Lösung für das System von partiellen Differentialgleichungen, **gekennzeichnet durch**:

Annähern einer groben Lösung (708) für das System von partiellen Differentialgleichungen;
Anwenden eines eingeschränkten Restdruckverfahrens, um ein System von linearen Druckgleichungen (710) aus der groben Lösung für das System von partiellen Differentialgleichungen zu gewinnen;
Anwenden eines Vorglättverfahrens (712) im kleinen Maßstab, um eine Näherungslösung für das System von linearen Druckgleichungen zu bestimmen;
Anwenden von mehrskaligem mehrstufigem Verarbeiten (714), um die Näherungslösung für das System von linearen Druckgleichungen zu verbessern;
Anwenden eines Nachglättverfahrens (716) im kleinen Maßstab, um die Näherungslösung für das System von linearen Druckgleichungen weiter zu verbessern; und
Lösen des Systems von partiellen Differentialgleichungen für verbleibende physikalische Parameter (718) auf Grundlage der weiter verbesserten Näherungslösung für das System von linearen Druckgleichungen; und
Ausgeben der Lösung an das System (722) von partiellen Differentialgleichungen.

2. Verfahren nach Anspruch 1, wobei das Ausgeben Anzeigen einer Darstellung eines Verhaltens des mindestens einen Fluids im Reservoir umfasst.

3. Verfahren nach Anspruch 1, ferner umfassend:

Vorhersagen von Fluidverhalten im Reservoir auf Grundlage des Systems von partiellen Differentialgleichungen; und
Entnehmen von Fluid aus dem Reservoir auf Grundlage der Vorhersage.

4. Verfahren nach Anspruch 1, wobei das Wiederholen parallel von mindestens einer Hardwaregrafikverarbeitungseinheit durchgeführt wird.

5. Verfahren nach Anspruch 1, ferner umfassend Vergleichen historischer Daten des Systems von partiellen Differentialgleichungen.

6. Verfahren nach Anspruch 1, wobei die physikalischen Parameter Druck, Strömungsrate und Zusammensetzung umfassen.

7. Verfahren nach Anspruch 1, wobei das Reservoir heterogene anisotrope poröse Medien umfasst.

8. Verfahren nach Anspruch 1, wobei mindestens eines von dem Anwenden eines Vorglättverfahrens und dem Anwenden eines Nachglättverfahrens Anwenden von mindestens einem Verfahren umfasst, das aus der Gruppe ausgewählt wurde, die aus Folgenden besteht: Anwenden von ILU(0), Anwenden eines Jacobi-Glättverfahrens und Anwenden eines Gauß-Seidel-Glättverfahrens.

9. Computersystem zum Modellieren des Verhaltens von mindestens einem Fluid in einem Reservoir, wobei das System mindestens einen elektronischen Prozessor und dauerhaften Speicher umfasst, der computerinterpretierbare Anweisungen speichert, die so konfiguriert sind, dass sie den mindestens einen Prozessor veranlassen, ein Verfahren auszuführen, das Folgendes umfasst:

Erlangen einer Mehrzahl von Messungen (702) von einer Mehrzahl von physikalischen Parametern an einer Mehrzahl von Standorten innerhalb des Reservoirs, wobei die Mehrzahl von physikalischen Parametern mindestens Druck umfasst;
Diskretisieren eines Systems von partiellen Differentialgleichungen (705), die auf Grundlage der Mehrzahl von Messungen die Mehrzahl von physikalischen Parametern modellieren;
Wiederholen für jeden einer Mehrzahl von Zeitschritten und bis zur Annäherung (706) an eine Lösung für das System von partiellen Differentialgleichungen, **gekennzeichnet durch**:

Annähern einer groben Lösung (708) für das System von partiellen Differentialgleichungen;
Anwenden eines eingeschränkten Restdruckverfahrens, um ein System von linearen Druckgleichungen (710) aus der groben Lösung für das System von partiellen Differentialgleichungen zu gewinnen;
Anwenden eines Vorglättverfahrens (714) im kleinen Maßstab, um eine Näherungslösung für das System von linearen Druckgleichungen zu bestimmen;
Anwenden von mehrskaligem mehrstufigem Verarbeiten (714), um die Näherungslösung für das System von linearen Druckgleichungen zu verbessern;
Anwenden eines Nachglättverfahrens (716) im kleinen Maßstab, um die Näherungslösung für das System von linearen Druckgleichungen weiter zu verbessern; und
Lösen des Systems von partiellen Differentialgleichungen für verbleibende physikalische Parameter (718) auf Grundlage der weiter verbesserten Näherungslösung für das System von linearen Druckgleichungen; und
Ausgeben der Lösung an das System (722) von partiellen Differentialgleichungen.

10. System nach Anspruch 9, wobei das Ausgeben Anzeigen einer Darstellung eines Verhaltens des mindestens einen Fluids im Reservoir umfasst.

11. System nach Anspruch 9, wobei die Anweisungen ferner so konfiguriert sind, dass sie den mindestens einen Prozessor dazu veranlassen, Folgendes auszuführen:

Vorhersagen von Fluidverhalten im Reservoir auf Grundlage des Systems von partiellen Differentialgleichungen; und
Entnehmen von Fluid aus dem Reservoir auf Grundlage der Vorhersage.

12. System nach Anspruch 9, ferner umfassend mindestens eine Grafikverarbeitungseinheit, wobei das Wiederholen parallel von der mindestens einen Hardwaregrafikverarbeitungseinheit durchgeführt wird.

13. System nach Anspruch 9, wobei die Anweisungen ferner so konfiguriert sind, dass sie den mindestens einen Prozessor dazu veranlassen, das Vergleichen historischer Daten des Systems von partiellen Differentialgleichungen durchzuführen.

14. System nach Anspruch 9, wobei die physikalischen Parameter Druck, Strömungsrate und Zusammensetzung umfassen.

15. System nach Anspruch 9, wobei das Reservoir heterogene anisotrope poröse Medien umfasst.

**Revendications**

1. Procédé informatique de modélisation de comportement d'au moins un fluide dans un réservoir, le procédé comprenant :

   l'obtention d'une pluralité de mesures (702) d'une pluralité de paramètres physiques au niveau d'une pluralité d'emplacements dans le réservoir, la pluralité de paramètres physiques comprenant au moins la pression ;
   la discrétisation d'un système d'équations différentielles partielles (704) qui modélisent, sur la base de la pluralité de mesures, la pluralité de paramètres physiques ;
   l'itération, pour chacune d'une pluralité d'étapes temporelles, et jusqu'à convergence (706) sur une solution au niveau du système d'équations différentielles partielles, **caractérisé en ce que** :

   l'approximation d'une solution brute (708) au niveau du système d'équations différentielles partielles ;
   l'application d'une technique résiduelle de pression de contrainte pour extraire un système d'équations linéaires de pression (710) de la solution brute au niveau du système d'équations différentielles partielles ;
   l'application d'une technique de pré-lissage (712) à petite échelle pour déterminer une solution approximative au niveau du système d'équations linéaires de pression ;
   l'application d'un traitement multiniveau à multi-échelle (714) pour améliorer la solution approximative au niveau du système d'équations linéaires de pression ;
   l'application d'une technique d'après lissage (716) à petite échelle pour améliorer davantage la solution approximative au niveau du système d'équations linéaires de pression ; et
   la résolution du système d'équations différentielles partielles pour les paramètres physiques restants (718) sur la base de la solution approximative davantage améliorée au niveau du système d'équations linéaires de pression ; et
   l'émission de la solution au niveau du système (722) d'équations différentielles partielles.

2. Procédé selon la revendication 1, dans lequel l'émission comprend l'affichage d'une représentation d'un comportement de l'au moins un fluide dans le réservoir.

3. Procédé selon la revendication 1, comprenant en outre :

   la prédiction du comportement du fluide dans le réservoir sur la base du système d'équations différentielles partielles ; et
   l'extraction du fluide du réservoir sur la base de la prédiction.

4. Procédé selon la revendication 1, dans lequel l'itération est réalisée en parallèle par au moins une unité de traitement graphique de matériel.

5. Procédé selon la revendication 1, comprenant en outre une mise en correspondance d'historique du système d'équations différentielles partielles.

6. Procédé selon la revendication 1, dans lequel les paramètres physiques comprennent la pression, le débit et la composition.

7. Procédé selon la revendication 1, dans lequel le réservoir comprend un milieu poreux anisotrope hétérogène.

8. Procédé selon la revendication 1, dans lequel au moins l'une parmi l'application d'une technique de pré-lissage et l'application d'une technique d'après lissage comprend l'application d'au moins une technique sélectionnée dans le groupe constitué de : l'application ILU(0), l'application d'un lisseur de Jacobi et l'application d'un lisseur de Gauss-Seidel.

9. Système informatique de modélisation de comportement d'au moins un fluide dans un réservoir, le système comprenant au moins un processeur électronique et une mémoire persistante stockant des instructions pouvant être interprétées par un ordinateur configurées pour faire en sorte que l'au moins un processeur exécute un procédé comprenant :

   l'obtention d'une pluralité de mesures (702) d'une pluralité de paramètres physiques au niveau d'une pluralité d'emplacements dans le réservoir, la pluralité de paramètres physiques comprenant au moins la pression ;

la discrétisation d'un système d'équations différentielles partielles (705) qui modélisent, sur la base de la pluralité de mesures, la pluralité de paramètres physiques ;

l'itération, pour chacune d'une pluralité d'étapes temporelles, et jusqu'à convergence (706) sur une solution au niveau du système d'équations différentielles partielles, **caractérisé en ce que** :

l'approximation d'une solution brute (708) au niveau du système d'équations différentielles partielles ;

l'application d'une technique résiduelle de pression de contrainte pour extraire un système d'équations linéaires de pression (710) de la solution brute au niveau du système d'équations différentielles partielles ;

l'application d'une technique de pré-lissage (714) à petite échelle pour déterminer une solution approximative au niveau du système d'équations linéaires de pression ;

l'application d'un traitement multiniveau à multi-échelle (714) pour améliorer la solution approximative au niveau du système d'équations linéaires de pression ;

l'application d'une technique d'après lissage (716) à petite échelle pour améliorer davantage la solution approximative au niveau du système d'équations linéaires de pression ; et

la résolution du système d'équations différentielles partielles pour les paramètres physiques restants (718) sur la base de la solution approximative davantage améliorée au niveau du système d'équations linéaires de pression ; et

l'émission de la solution au niveau du système (722) d'équations différentielles partielles.

10. Système selon la revendication 9, dans lequel l'émission comprend l'affichage d'une représentation d'un comportement de l'au moins un fluide dans le réservoir.

11. Système selon la revendication 9, dans lequel les instructions sont en outre configurées pour faire en sorte que l'au moins un processeur réalise :

la prédiction du comportement du fluide dans le réservoir sur la base du système d'équations différentielles partielles ; et

l'extraction du fluide du réservoir sur la base de la prédiction.

12. Système selon la revendication 9 comprenant en outre au moins une unité de traitement graphique, dans lequel l'itération est réalisée en parallèle par l'au moins une unité de traitement graphique de matériel.

13. Système selon la revendication 9 dans lequel les instructions sont en outre configurées pour faire en sorte que l'au moins un processeur effectue la mise en correspondance d'historique du système d'équations différentielles partielles.

14. Système selon la revendication 9, dans lequel les paramètres physiques comprennent la pression, le débit et la composition.

15. Système selon la revendication 9, dans lequel le réservoir comprend un milieu poreux anisotrope hétérogène.

**CPR-GMS / CPR-NGMS**

1. BUILD FINE SCALE JACOBIAN (J) AND RESIDUAL (R)
2. APPLY CPR PRECONDITIONING: $A_{cpr} = C^T \cdot M \cdot J \cdot C$

3. FINE SCALE PRE-SMOOTHING ($\Delta \overline{x}_p$ - INITIAL GUESS):

$$\Delta x_p = \Delta \overline{x}_p + S^{-1}(R^* - A_{cpr}\Delta \overline{x}_p)$$

4. APPLY $W^T$ & W (FORM $A_{cpr}^{GMS}$ OR $A_{cpr}^{NGMS}$):

$$A_{cpr}^{GMS} = W^T A_{cpr}W, \quad R_c = W^T R^*, \ \Delta \tilde{x}_{p_c} = W^T \Delta x_p$$

$$A_{cpr}^{NGMS} = NG(A_{cpr}^{GMS}), \ \tilde{R}_c = NG(R_c), \ \Delta \tilde{x}_{p_c} = W^T \Delta x_p$$

5. SOLVE FOR $\Delta x_{p_c}$: $A_{cpr}^{GMS} \cdot \Delta x_{p_c} = R_c$ OR $A_{cpr}^{NGMS} \cdot \Delta x_{p_c} = \tilde{R}_c$

6. OBTAIN FINE SCALE PRESSURE: $\Delta \hat{x}_p = P \cdot \Delta x_{p_c}$
7. FINE SCALE POST-SMOOTHING:

$$\Delta x_p = \Delta \hat{x}_p + S^{-1}(R^* - A_{cpr}\Delta \hat{x}_p)$$

8. CORRECT RESIDUAL: $R^* = R - J \cdot (C \cdot \Delta x_p)$
9. SOLVE THE NEW FULL SYSTEM: $J \cdot \Delta x^* = R^*$
10. COMBINE THE 2 SOLUTIONS: $\Delta x = \Delta x^* + \Delta x_p$
11. UPDATE SOLUTION: $x^{n+1} = x^n + \Delta x$
12. CHECK RESIDUALS

# FIG. 1

FIG. 2

FIG. 3

EP 2 960 430 B1

FIG. 4

26

FIG. 5

FIG. 6

```
┌─────────────────────────────┐
│   OBTAIN MEASUREMENTS       │──702
└─────────────────────────────┘
              │
              ▼
┌─────────────────────────────┐
│ DISCRETIZE SYSTEM OF PARTIAL │──704
│   DIFFERENTIAL EQUATIONS     │
└─────────────────────────────┘
              │
              ▼
┌─────────────────────────────┐
│ FOR EACH OF A PLURALITY OF   │──706
│   TIME STEPS, UNTIL          │
│       CONVERGENCE            │
└─────────────────────────────┘
              │
              ▼
┌─────────────────────────────┐
│      APPROXIMATE             │──708
│     ROUGH SOLUTION           │
└─────────────────────────────┘
              │
              ▼
┌─────────────────────────────┐
│       UPDATE                 │──709
│      RESIDUALS               │
└─────────────────────────────┘
              │
              ▼
┌─────────────────────────────┐
│ EXTRACT SYSTEM OF PRESSURE   │──710
│     LINEAR EQUATIONS         │
└─────────────────────────────┘
              │
              ▼
┌─────────────────────────────┐
│  APPLY PRE-SMOOTHING         │──712
│      TECHNIQUE               │
└─────────────────────────────┘
              │
              ▼
┌─────────────────────────────┐
│  APPLY MULTI-SCALE           │──714
│  MULTI-LEVEL PROCESSING      │
└─────────────────────────────┘
              │
              ▼
┌─────────────────────────────┐
│  APPLY POST-SMOOTHING        │──716
│      TECHNIQUE               │
└─────────────────────────────┘
              │
              ▼
┌─────────────────────────────┐
│  SOLVE FOR REMAINING         │──718
│  PHYSICAL PARAMETERS         │
└─────────────────────────────┘
              │
              ▼
    NO   ◇ DONE? ◇──720
  ◄──────
              │ YES
              ▼
┌─────────────────────────────┐
│     OUTPUT SOLUTION          │──722
└─────────────────────────────┘
```

FIG. 7

29

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110098998 A